# EUROPEAN PATENT APPLICATION

(11) **EP 2 081 211 A1**
(43) Date of publication of application: **22.07.2009**
(21) Application number: 08100490.5
(22) Date of filing: 15.01.2008
(51) Int. Cl.: H01J 37/32

(54) **Improving abrasion resistance of surfaces**

(71) Applicant: Agilent Technologies, Inc., Santa Clara CA 95051 (US)
(72) Inventor: Baeuerle, Martin, 77830, Buehlertal (DE)
(74) Representative: Barth, Daniel Mathias

(57) **Abstract**

A method for increasing abrasion resistance of a microfluidic device is described. The microfluidic device comprises a surface that is exposed to wear of friction. The method comprises hardening the surface by implanting ions into the surface.

## Description

### BACKGROUND ART

The present invention relates to a method for increasing abrasion resistance of a microfluidic device, and to a microfluidic device comprising a surface exposed to wear of friction.

In microfluidics, structure sizes of fluid conduits become smaller, and correspondingly, fluid pressure increases. Wear of friction of the structures of a microfluidic device often impairs performance of the microfluidic device, especially in case the microfluidic device comprises e.g. switching members or micro valves. For ensuring long-term operability of a microfluidic device, abrasion resistance of the stressed surfaces is an important issue.

### DISCLOSURE

It is an object of the invention to provide an improved abrasion resistance of a microfluidic device. The object is solved by the independent claim(s). Further embodiments are shown by the dependent claim(s).

According to embodiments of the present invention, a method for increasing abrasion resistance of a microfluidic device is provided. The microfluidic device comprises a surface that is exposed to wear of friction. The method comprises hardening the surface by implanting ions into the surface.

A microfluidic device may comprise one or more surfaces that are particularly exposed to mechanical stress, to wear of friction and to abrasion. For increasing the resistiveness of the respective surface, it is proposed to treat these surfaces using ion implantation.

In ion implantation, ions are accelerated towards the surface, penetrate into the material and are stopped at a certain penetration depth. As a result, the near-surface region of the material is modified in the first place. The implanted ions cause an increase of surface durability, the resistiveness of the respective surface is improved. Abrasion due to wear of friction is reduced, and thus, lifetime of the respective microfluidic device is prolonged. Microfluidic components that are exposed to wear of friction don't have to be replaced as frequently as in prior art solutions. Hence, the cost for maintaining a microfluidic system is reduced. Due to the system's improved abrasion resistance, failures will occur less frequently, the service efforts can be lowered, and the customer's satisfaction with the product rises. Hence, embodiments of the present invention provide an important contribution to reliability of microfluidic systems.

According to a preferred embodiment, the surface is a polymeric surface. Polymeric materials are often used for applications in the field of microfluidics. For many commonly used polymeric materials, surface durability is quite low. Ion implantation is a suitable technique for improving the durability and abrasion resistance of polymeric materials.

According to a preferred embodiment, implanting ions comprises implanting carbon ions into the surface. According to an alternatively preferred embodiment, ionized atoms of any one of Group 13, 14, 15, 16 of the periodic table are implanted.

According to a preferred embodiment, implanting ions is effected by plasma immersion ion implantation. In plasma immersion ion implantation, a plasma of ionized atoms and electrons is generated. The ions are accelerated by an electrical field towards the surface of the microfluidic device and implanted into the surface. The microfluidic device may be surrounded by the plasma, and for this reason, even microfluidic devices of rather complex shape may be homogenously exposed to ion implantation.

According to a preferred embodiment, ions are implanted at a density between 10¹⁴ ions per cm² and 10¹⁸ ions per cm².

According to a preferred embodiment, implanting ions comprises generating a plasma, extracting ions from the plasma, and applying an accelerating voltage to accelerate the ions towards the surface. Preferably, the plasma is an electropositive plasma comprising positively charged ions. Further preferably, generating the plasma comprises heating up and ionizing a gas, preferably methane. Methane is a suitable working gas for generating carbon ions.

According to a preferred embodiment, the accelerating voltage is applied between a plasma electrode and the surface of the microfluidic device. Thus, charged ions are accelerated towards the surface of the microfluidic device, impinge on the surface and penetrate into the material.

According to a preferred embodiment, a pulsed accelerating voltage is applied between a plasma electrode and the surface of the microfluidic device. By employing a pulsed acceleration voltage, the thermal impact on the target can be reduced.

According to a preferred embodiment, the accelerating voltage lies in the range between 50 kV and 180 kV. The average penetration depth of the implanted ions strongly depends on the acceleration voltage. A suitable choice of the acceleration voltage therefore determines the near-surface region where the implanted ions are stopped.

According to embodiments of the present invention, a microfluidic device is provided, the microfluidic device comprising a surface exposed to wear of friction, wherein the surface is a hardened surface comprising ions implanted into the surface by an ion implantation technique.

According to a preferred embodiment, the surface is made of one of: polyimide, PEEK. Polyimide and polyetheretherketone (PEEK) are solvent-resistant polymeric materials that are often used in microfluidic applications. It has been found that ion implantation is a suitable technique for improving surface durability and long-term stability of polymeric surfaces, in particular polyimide and PEEK surfaces.

According to a preferred embodiment, the microfluidic device comprises a stationary part and a movable member adapted to move relative to the stationary part, at least one of the stationary part and the movable member being a component having the hardened surface. The component having the hardened surface comprises a polymeric surface, the polymeric surface being exposed to wear of friction that is due to the component's relative movement, the polymeric surface being a hardened polymeric surface comprising ions implanted by an ion implantation technique.

Especially when two surfaces frequently slide or move relative to one another, the contact surfaces are particularly exposed to wear of friction. In microfluidic devices of the prior art, it has been necessary to replace the wear and tear parts of a microfluidic system on a regular basis. By subjecting the contact surfaces to ion implantation, their lifetime is significantly increased, and reliability of operation is improved.

According to a preferred embodiment, at least one face of the movable member is adapted for sliding along at least one face of the stationary part. Preferably, the movable member is adapted for being set to at least two different positions relative to the stationary part.

According to a preferred embodiment, the stationary part comprises one or more fluid ports adapted for establishing fluid connections with corresponding fluid ports of the movable member.

According to a preferred embodiment, the movable member is adapted for switching between two or more different flow paths of the microfluidic device. For example, the movable member may be part of a micro switch or micro valve. Preferably, the polymeric surface is implemented as a fluid-tight sealing surface. When a sealing surface is exposed to wear of friction, its sealing properties may be impaired, and leakage starts to occur. For ensuring fluid-tight connections, surface durability is an important issue.

According to a preferred embodiment, the movable member is adapted for being set to at least two different positions relative to the stationary part, wherein in each of the different positions, different fluidic connections between the stationary part and the movable member are established and/or disconnected.

According to a preferred embodiment, the microfluidic device is adapted for pressing the movable member against the stationary part in a fluid-tight manner. In case of high fluid pressure, a pressing force of large magnitude may be required for accomplishing fluid-tight connections. However, a large pressing force causes an increased wear of friction. By applying ion implantation techniques to a sealing surface or contact surface, the respective surface is hardened. Even when large pressing forces are applied, wear of friction is kept small, and long-term stability of the movable member and the stationary part is ensured.

According to a preferred embodiment, the movable member is a rotor element, the rotor element being pivotable around an axis of rotation perpendicular to the polymeric surface. Preferably, the rotor element is adapted for being rotated into at least two different positions relative to the stationary part.

According to a preferred embodiment, the rotor element is a component of a micro valve, and the stationary part serves as a stator element of the micro valve. Microfluidic valves have to reliably operate at high fluid pressures. By subjecting at least one of the stator's and the rotor's surfaces to a surface hardening technique, the durability of the micro-valve is improved.

According to a preferred embodiment, the rotor element is adapted for switching between different flow paths of the microfluidic device.

According to an alternative preferred embodiment, the movable member is adapted for being linearly moved into at least two different positions relative to the stationary part. Further preferably, the movable member is a component of a microfluidic switch. A linear movement of the movable member also causes wear of friction. Also in this case, an ion implantation treatment may improve durability of the contact surfaces.

According to a preferred embodiment, the stationary part is implemented as a multilayer structure. Preferably, the stationary part is composed of a stack of microstructured polymeric foils.

According to a preferred embodiment, the stationary part comprises a separation system adapted for separating compounds of a given sample; wherein preferably the separation system is adapted for performing at least one of: liquid chromatography, gel electrophoresis, electrochromatography.

According to a preferred embodiment, at least one of the stationary part and the movable member is made of polymeric material, preferably of one of: polyimide, PEEK.

### BRIEF DESCRIPTION OF DRAWINGS

Other objects and many of the attendant advantages of embodiments of the present invention will be readily appreciated and become better understood by reference to the following more detailed description of embodiments in connection with the accompanied drawing(s). Features that are substantially or functionally equal or similar will be referred to by the same reference sign(s).

Fig. 1 shows a microfluidic device with a microvalve and an actuation mechanism for the microvalve;

Fig. 2 gives a more detailed view of the microvalve;

Fig. 3shows the two positions of the microvalve;

Fig. 4depicts a microfluidic chip adapted for separating and analysing compounds of a sample;

Fig. 5shows an apparatus for plasma immersion ion implantation;

Fig. 6illustrates the path of an accelerated ion that penetrates into a solid; and

Fig. 7shows an ion accelerator.

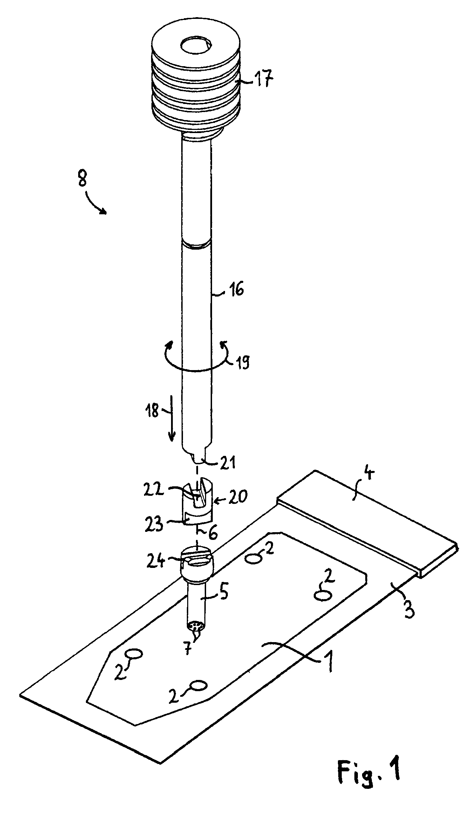

Fig. 1 shows a microfluidic chip 1 together with a switching valve, the switching valve being adapted for switching between different flow paths of the microfluidic chip 1. Furthermore, an actuation mechanism for the switching valve is depicted. Preferably, the microfluidic chip 1 is made of polymeric material. For example, the microfluidic chip 1 may be realized as a multilayer structure comprising 2, 3 or more layers of microstructured polymeric foils. Each of the laminated foils comprises positioning holes 2 to ensure an exact positioning of the polymeric layers relative to one another. The microfluidic chip 1 is supported by a metal frame 3, the metal frame 3 being adapted for protecting the microfluidic chip 1. In order to simplify replacement of the microfluidic chip 1, a plastic handle 4 may be fixed to the metal frame 3.

The switching valve shown in Fig. 1 is adapted for switching between different flow paths of the microfluidic chip 1. The switching valve comprises a rotor element 5 that may be pivoted around an axis of rotation 6. The microfluidic chip 1 represents the stator of the switching valve and comprises a set of stator ports 7 located underneath the rotor element 5. The rotor element 5 may be rotated to a plurality of different rotor positions. By setting the rotor element 5 to different rotor positions, different fluid connections between the stator ports 7 may be established and/or disconnected. An actuation mechanism 8 is adapted for pressing the rotor element 5 against the upper surface of the microfluidic chip 1. Thus, even at a fluid pressure of 200 bar or even more, fluid-tight connections between the rotor element 5 and the stator ports 7 can be set up.

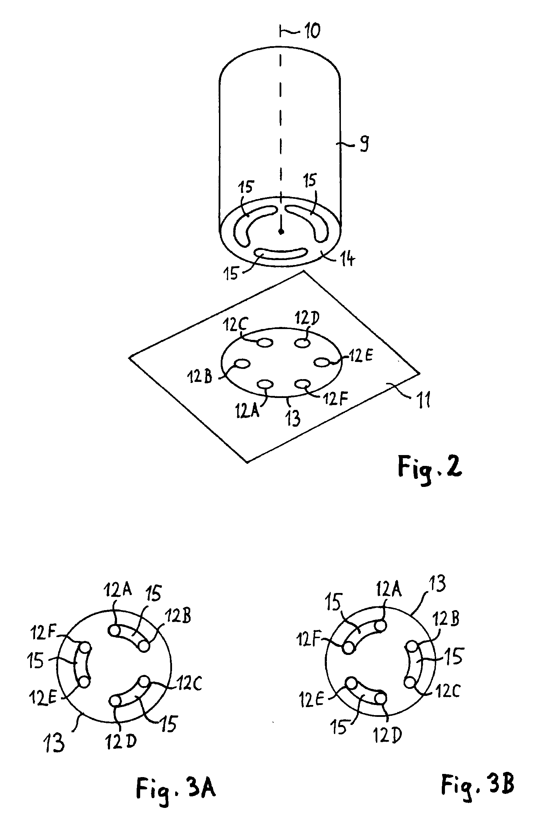

Fig. 2 gives a more detailed view of the switching valve. The switching valve comprises a rotor element 9 that may be pivoted around an axis of rotation 10. The switching valve is a 2-position/6-port switching valve, with the microfluidic chip 11 comprising a set of six stator ports 12A to 12F located within a circular area 13. The lower surface 14 of the rotor element 9 comprises three switching channels 15, which are implemented as grooves in the lower surface 14. When the lower surface 14 of the rotor element 9 is pressed onto the circular area 13 of the microfluidic chip 11, the switching channels 15 may establish fluidic connections between adjacent ones of the stator ports 12A to 12F.

In a 2-position/6-port switching valve, the rotor element 9 can be rotated to two different positions relative to the stator ports 12A to 12F. Fig. 3A shows the fluidic connections for the case of the rotor element 9 being set to its respective first position. In this position, the switching channels 15 provide fluidic connections between the stator ports 12A and 12B, between the stator ports 12C and 12D, and between the stator ports 12E and 12F. A rotation of 60°, either in the clockwise or in the counterclockwise direction, will set the rotor element 9 to a respective second position relative to the stator ports. In Fig. 3B, the second position of the rotor element 9 and the resulting fluid connections are illustrated. In the rotor element's second position, the switching channels 15 provide fluidic connections between the stator ports 12B and 12C, between the stator ports 12D and 12E, and between the stator ports 12F and 12A.

The actuation mechanism 8 shown in Fig. 1 is adapted for rotating the rotor element 5, and for pressing the rotor element 5 against the surface of the microfluidic chip 1. The actuation mechanism 8 comprises a drive shaft 16 and a spring member 17, the spring member 17 being adapted for exerting a force 18 onto the drive shaft 16. The force 18 is of sufficient magnitude to provide for a fluid-tight coupling between the rotor element 5 and the stator ports 7 of the microfluidic chip 1.

For switching the rotor element 5, a rotary movement 19 of the drive shaft 16 is transferred to the rotor element 5 via an intermediate piece 20. The lower end of the drive shaft 16 comprises a tongue 21 that engages with a corresponding groove 22 on the upper side of the intermediate piece 20. The lower side of the intermediate piece 20 comprises a tongue 23 that engages with a corresponding groove 24 on the upper side of the rotor element 5. Any rotary movement 19 of the drive shaft 16 is transferred, via the intermediate piece 20, into a corresponding rotary movement of the rotor element 5. The tongue 21 and the groove 22 on the upper side of the intermediate piece 20 are perpendicular to the tongue 23 and the groove 24 on the lower side of the intermediate piece 20. Therefore, the intermediate piece 20 acts as an Oldham coupler, whereby the drive shaft 16 may be inclined in any direction relative to the axis 6 of the rotor element 5. This mechanical setup provides for some degree of freedom for adjusting the lower face of the rotary element 5 to the microfluidic chip's surface. As a result, the lower face of the rotor element 5 seats solidly on the corresponding circular area of the microfluidic chip 1, whereby a fluid-tight coupling between the rotor element 5 and the microfluidic chip 1 is accomplished.

The microfluidic chip 1 may for example comprise a separation system for separating and analyzing compounds of a given sample. For separating the sample's compounds, separation techniques like for example liquid chromatography, gel electrophoresis or electrochromatography may be employed.

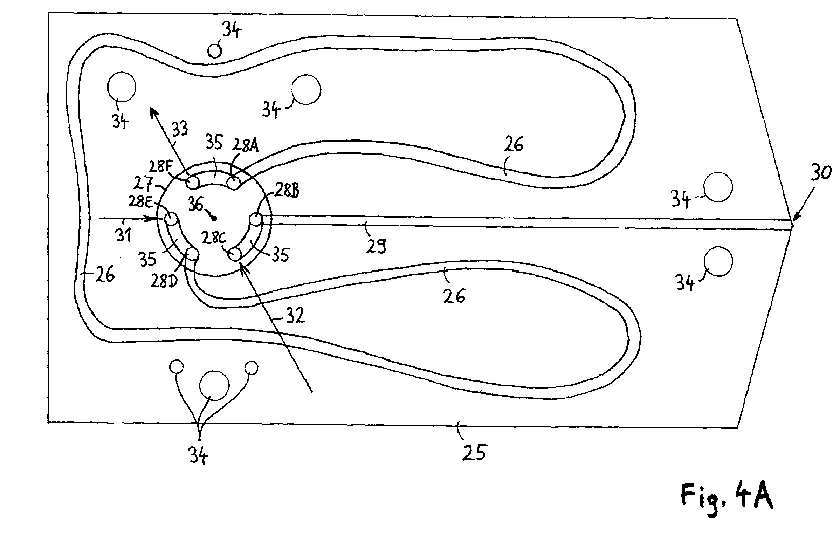

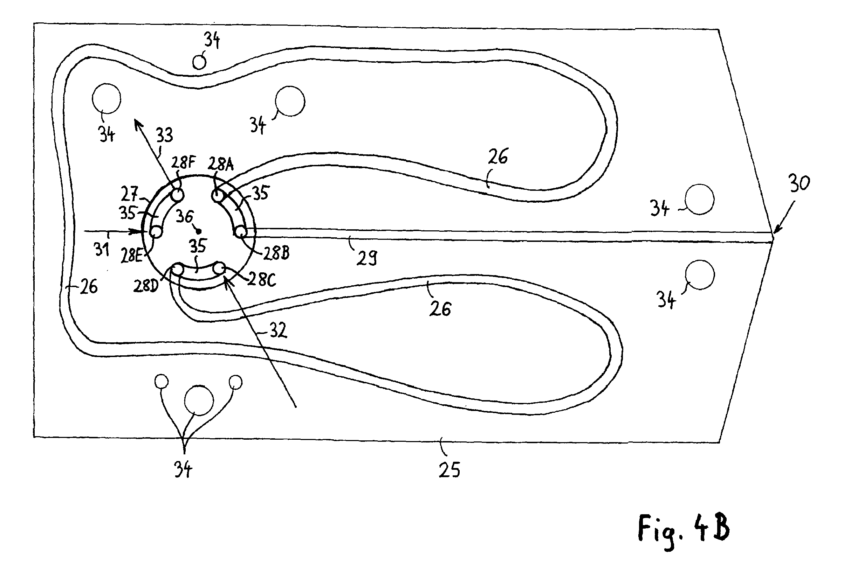

Figs. 4A and 4B illustrate the operation of a microfluidic chip 25 that is adapted for separating and analyzing compounds of a fluid sample. The microfluidic chip 25, which is shown from above, comprises a separation column 26 filled with packing material. The microfluidic chip 25 further comprises a 2-position/6-port multiroute valve 27 with six stator ports 28A to 28F. Port 28D of the multiroute valve 27 is connected with the inlet of the separation column 26, and the outlet of the separation column 26 is connected with port 28A of the multiroute valve 27. In the example of Figs. 4A and 4B, after the compounds of the fluid sample have been separated, mass spectroscopy is used for detecting the sample's compounds. A microchannel 29 couples port 28B of the multiroute valve 27 with an electrospray nozzle 30 at the tip of the microfluidic chip 25. The electrospray nozzle 30 is adapted for vaporizing the components of the fluid sample, which are then provided to a mass spectroscopy unit.

The microfluidic chip 25 comprises separate inlets for sample and mobile phase. A sample inlet 31 is coupled with port 28E, and a mobile phase inlet 32 is coupled with port 28C of the multiroute valve 27. Port 28F of the multiroute valve 27 is connected with a waste outlet 33.

The microfluidic chip 25 can be realized as a multilayer structure comprising two or more microstructured polymeric films. For example, the microfluidic chip 25 shown in Fig. 4A and 4B may be composed of a top layer, a medium layer and a bottom layer. The three layers can be made of a polymeric material. Preferably, a solvent-resistant polymer like for example polyimide or polyetheretherketone (PEEK) is used, with the thickness of the polymeric foil being in the range between 10µm and 300µm.

For microstructuring the layers of polymeric foil, there exist a variety of different techniques. These techniques comprise molding, for example microinjection molding, hot embossing, laser ablation, various etching techniques like for example dry etching, wet etching, plasma etching, reactive ion etching (RIE), etc. After microstructuring of the polymeric foil has been performed, the microstructured layers are bonded, and a multilayered chip device is formed. To provide for a precise alignment of the various layers relative to each other, each of the layers comprises several positioning holes 34.

The multiroute valve 27 comprises a rotor element of the kind shown in Figs. 1 to 3. The rotor element's lower face comprises three grooves 35, with each of the grooves 35 providing a fluid connection between two adjacent ports of the multiroute valve 27. By pivoting the rotor element around an axis of rotation 36, the multiroute valve 27 can be set to two different positions.

In Fig. 4A, the multiroute valve 27 is set to its respective first position. In this position, sample can be loaded into the separation column 26. For this purpose, the sample inlet 31 is connected, via one of the rotor's grooves 35, with the inlet of the separation column 26. The outlet of the separation column 26 is coupled, via another groove 35, with the waste outlet 33. The sample inlet 31 may for example be coupled with a first pump, the first pump being operative to pump a fluid sample through the separation column 26 to the waste outlet 33. During the sample loading phase, sample compounds of interest are trapped at the separation column's head. Fluid sample may for example be transported through the separation column 26 for a certain period of time, to accomplish an enrichment of the sample compounds at the separation column's head. Interfering moieties such as for example salts, which may obstruct further detection, are washed to the waste outlet 33.

During the sample loading phase, the mobile phase inlet 32 is connected, via another groove 35 and via the microchannel 29, with the electrospray nozzle 30. The mobile phase inlet 32 may be coupled with a second pump that is adapted for supplying a flow of mobile phase. During the sample loading phase, a constant flow of mobile phase through the electrospray nozzle 30 is kept up, and hence, liquid flow through the electrospray nozzle 30 is not disrupted.

After the sample has been loaded, the multiroute valve 27 is switched to its second position, which is shown in Fig. 4B. In the valve's second position, the sample's compounds are separated and analyzed. The sample inlet 31 is connected, via one of the grooves 35, with the waste outlet 33. The mobile phase inlet 32 is coupled with the inlet of the separation column 26, and the separation column's outlet is connected, via the microchannel 29, with the electrospray device.

For separating the sample's compounds, a mobile phase with a constant proportion of different solvents may be supplied to the separation column 26. In this case, the time required for a particular component to pass through the separation column 26 solely depends on the components' interaction with the mobile phase and the stationary phase. According to an alternative embodiment, a mobile phase gradient with a continuously increasing amount of organic solvent may be supplied to the separation column 26. By continuously increasing the elution strength, the compounds of the sample trapped at the column's head are separated according to one of molecular weight, size, polarity, charge, hydrophobicity, etc.

After being separated, the sample's compounds are successively supplied to the electrospray nozzle 30, in order to be analyzed by the mass spectroscopy unit. After all the components contained in the sample have been analyzed, the separation column 26 is reconditioned. Then, the multiroute valve 27 may be switched back to the sample loading position shown in Fig. 4A.

Each time a switching valve is operated, the rotor element is rotated around an axis of rotation while being pressed against the polymeric surface. For example, the rotor element 5 shown in Fig. 1 is constantly pressed against the polymeric surface of the microfluidic chip 1 with a certain force 18. As a consequence, the polymeric surface is exposed to wear of friction. After a multitude of switching operations, a footprint of the rotor element is formed in the upper surface of the microfluidic chip 1. Furthermore, due to abrasion, fluffs of polymeric material are formed on the surface of the microfluidic chip 1. The presence of these polymeric fluffs further enhances abrasion. The polymeric fluffs may be washed into the system of fluid conduits of the microfluidic chip 1. In case the microfluidic chip 1 comprises microfilters, the presence of these fluffs may lead to clogging of the filter pores.

Due to all the problems related to wear of friction, after a certain number of switching operations, the sealing properties of the switching valve are no longer satisfactory. In nowadays microfluidic systems, the leakage rate of a switching valve must not exceed 10 nl per minute. It has be observed that after several hundred switching operations, the switching valve's leakage rate exceeds this limit, and hence, the microfluidic chip 1 has to be replaced. However, even replacement of the microfluidic chip 1 may not necessarily solve the problems related to abrasion, because fluffs of polymeric material may still adhere to the lower face of the rotor element 5. These polymeric fluffs are carried over to the new chip's surface, where they give rise to continued abrasion. As a consequence, the sealing properties of the new chip will soon degrade, and another replacement of the microfluidic chip will become necessary.

According to embodiments of the present invention, for improving the abrasion resistance of the microfluidic chip's polymeric surface, the polymeric surface is subjected to a surface hardening process. Preferably, surface hardening is effected by implanting ions into the polymeric surface using an ion implantation technique. Ion implantation is a materials engineering process by which ions of a material can be implanted into another solid, thereby changing the physical properties of the solid. For example, by implanting carbon ions into a polymeric material at a density between 10¹⁴ ions per cm² and 10¹⁸ ions per cm², the surface of the polymeric material is hardened, and the resistance to wear of friction is improved. Instead of carbon ions, ionized atoms of any one of group 13, 14, 15, 16 of the periodic table may be implanted into the polymeric material to improve the material's abrasion resistance.

By applying ion implantation to the surface of the microfluidic chip 1 shown in Fig. 1, the surface's resistance to wear of friction can be considerably improved. As a consequence, the lifetime of the switching valve may be prolonged, and the microfluidic chip does not have to be replaced as often as before. A hardened chip surface allows for about 1000 or even more switching operation before leakage of the microvalve starts to become a problem. Due to the increased abrasion resistance, formation of polymeric fluffs is prevented.

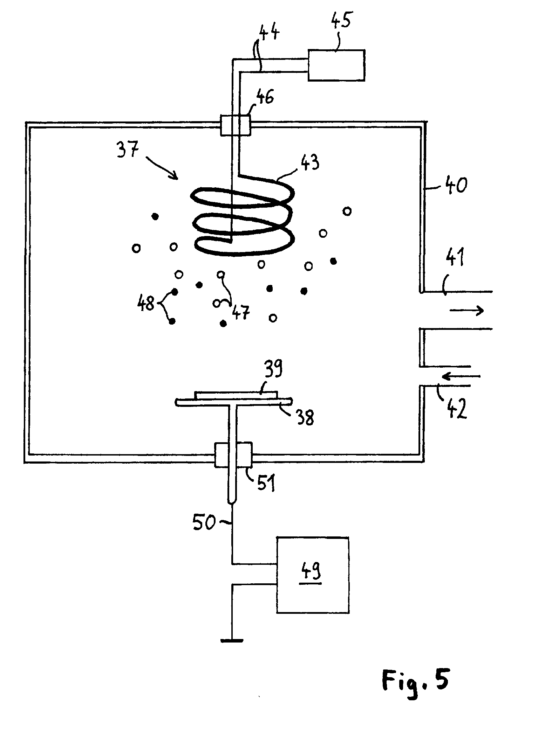

Plasma immersion ion implantation is a suitable technique for implanting ions into a solid. Fig. 5 shows an apparatus for plasma immersion ion implantation. The apparatus comprises a plasma source 37 and a sample holder 38 adapted for holding a substrate 39. Both the plasma source 37 and the sample holder 38 are located in a vacuum chamber 40. The vacuum chamber 40 has a connection 41 for one or more vacuum pumps adapted for evacuating the vacuum chamber 40. Depending on the respective process requirements, a vacuum between 10⁻⁴ bar and 10⁻¹⁰ bar is generated. The vacuum chamber 40 further comprises an inlet 42 for supplying a working gas to the vacuum chamber 40. For example, for generating a plasma of carbon ions and electrons, methane (CH₄) is used as a working gas.

Various different types of plasma sources may be employed for generating a plasma, like for example an electron cyclotron resonance (ECR) plasma source, a helicon plasma source, a capacitively coupled plasma source (CCP source), an inductively coupled plasma source (ICP source), a DC glow discharge source, and, for metallic species, a metal vapor arc. In the example of Fig. 5, an inductively coupled plasma source 37 is employed. The plasma source 37 comprises a radiofrequency (RF) antenna 43 that is connected, via respective supply lines 44, with a RF generator 45. The supply lines 44 pass through a lead through 46, in order to electrically insulate the supply lines 44 from the walls of the vacuum chamber 40.

By supplying an RF current at a frequency of about 13 MHz to the RF antenna 43, an alternating magnetic field is generated, the alternating magnetic field being operative to ionize the atoms of the working gas. Around the RF antenna 43, a plasma comprising positively charged ions 47 and electrons 48 is generated

For extracting the positively charged ions 47 and accelerating the ions 47 towards the substrate 39, a high voltage pulsed DC or pure DC voltage is applied to the sample holder 38 and the sample 39. For accelerating and implanting positively charged ions, the sample holder 38 and the substrate 39 are set to a negative potential relative to the plasma source 37. By applying a pulsed DC voltage instead of a pure DC voltage, thermal impact on the substrate 39 may be decreased. The pulsed DC voltage or pure DC voltage is generated by a high voltage power supply 49 that is connected to the sample holder 38 via a voltage supply line 50. The voltage supply line 50 passes through a lead through 51, in order to electrically insulate the voltage supply line 50 from the chamber wall. The voltage provided by the high voltage power supply 49 is typically in the range between 10 kV and 500 kV, further preferably in the range between 70 kV and 150 kV.

The positively charged ions 47 are accelerated towards the negatively charged substrate 39, impinge on the substrate 39 and penetrate into the substrate 39 until they are stopped. Thus, positively charged ions 47 are implanted in a near-surface region of the substrate 39. Ion implantation is especially useful in cased where the respective structural change is desired to be near the surface of the target.

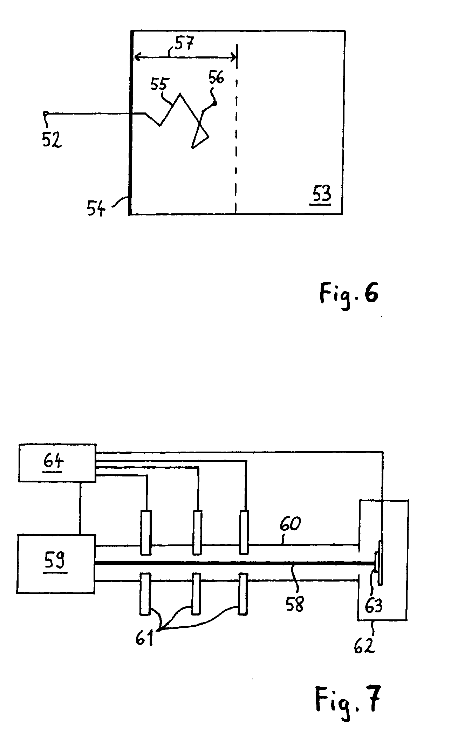

Fig. 6 shows an ion 52 that is implanted into a solid 53, e.g. into a polymeric material. The ion 52 is accelerated towards the solid 53 by an electrostatic potential, passes the surface 54 and travels through the solid 53 along a path 55. The ion 52 gradually loses its energy as it travels through the solid 53. The loss of energy is due to occasional collisions with target atoms, which cause abrupt energy transfers, and to a mild drag from overlap of electron orbitals, which is a continuous process. The loss of energy in the solid 53 is referred to as stopping. As a result of the interactions of the ion 52 with the atoms of the solid 53, the ion 52 comes to rest at a position 56.

A mono-energetic ion beam will generally have a broad depth distribution. The energy of the ions, the ion species and the composition of the target determines the average penetration depth 57 of the ions. The average penetration depth 57 of the ions is called the range of the ions. For a typical acceleration voltage between 10 kV and 500 kV, the range of the ions will be between 10 nm and 1 µm. For increasing abrasion resistance of a polymeric material, good results have been obtained by implanting carbon ions at an average penetration depth of about 30 nm.

In Fig. 5, a plasma immersion ion implantation apparatus has been described. However, other ion implantation techniques may be used as well for implanting ions into a polymeric material. For example, in Fig. 7, an ion accelerator is shown, the ion accelerator being adapted for providing a beam 58 of positively charged ions. The ion accelerator comprises an ion source 59, a tube 60 with a plurality of ring-shaped electrodes 61 and a target chamber 62 with a target 63. The ion source 59, the tube 60 and the target chamber 62 are evacuated. The ion accelerator further comprises a high-voltage power supply 64 for providing voltages required for the ion accelerator's operation. An acceleration voltage is applied between the ion source 59 and the target 63, whereby the target 63 is set to a negative potential relative to the ion source 59. Furthermore, for defining the shape of the ion beam 59, each of the ring-shaped electrodes 61 may be set to a predefined potential. The ion beam 59 impinges on the surface of the target 63, and the positively charged ions penetrate into the target material. Each of the ions is stopped at a certain depth. After a predefined period of time, the target 63 comprises a certain concentration of implanted ions. As a result, the surface of the target 63 is hardened, and abrasion resistance of the target 63 is improved.

Ion implantation may be used for hardening the surface of a microfluidic chip made of polymeric material. However, additionally or alternatively, ion implantation may as well be used for hardening a surface of the movable member, e.g. the lower face of the rotor element. Generally speaking, whenever a part of a microfluidic device is exposed to wear of friction, it may be advantageous to subject that part to a surface treatment according to embodiments of the present invention.

## Claims

1. A method for increasing abrasion resistance of a microfluidic device (1), the microfluidic device (1) comprising a surface (54) that is exposed to wear of friction, the method comprising
hardening the surface (54) by implanting ions (52) into the surface.

2. The method of claim 1, comprising at least one of:
the surface is a polymeric surface;
implanting ions comprises implanting carbon ions into the surface;
implanting ions comprises implanting ionized atoms of any one of Group 13, 14, 15, 16 of the periodic table;
implanting ions is effected by plasma immersion ion implantation;
ions are implanted at a density between 10¹⁴ ions per cm² and 10¹⁸ ions per cm².

3. The method of claim 1 or any one of the above claims, wherein implanting ions comprises:
generating a plasma;
extracting ions from the plasma;
applying an accelerating voltage to accelerate the ions towards the surface.

4. The method of the preceding claim, further comprising one or more of the following:
the plasma is an electropositive plasma comprising positively charged ions;
generating the plasma comprises heating up and ionizing a gas, preferably methane;
the accelerating voltage is applied between a plasma electrode and the surface of the microfluidic device;
a pulsed accelerating voltage is applied between a plasma electrode and the surface of the microfluidic device;
the accelerating voltage lies in the range between 50 kV and 180 kV;

5. A microfluidic device (1), the microfluidic device (1) comprising a surface (54) exposed to wear of friction,
wherein the surface (54) is a hardened surface comprising ions (52) implanted into the surface (54) by an ion implantation technique.

6. The microfluidic device of the preceding claim, further comprising one or more of the following:
the surface is a polymeric surface;
the ions implanted into the surface comprise carbon ions;
the ions implanted into the surface comprise ionized atoms of any one of Group 13, 14, 15, 16 of the periodic table;
the density of implanted ions lies between 10¹⁴ ions per cm² and 10¹⁸ ions per cm²;
plasma immersion ion implantation is employed as the ion implantation technique;
the surface is made of one of: polyimide, PEEK.

7. The microfluidic device of claim 5 or any one of the above claims, comprising
a stationary part,
a movable member adapted to move relative to the stationary part,
at least one of the stationary part and the movable member being a component having the hardened surface, and
the component having the hardened surface comprises a polymeric surface, the polymeric surface being exposed to wear of friction that is due to the component's relative movement, the polymeric surface being a hardened polymeric surface comprising ions implanted by an ion implantation technique.

8. The microfluidic device of the preceding claim, comprising at least one of:
at least one face of the movable member is adapted for sliding along at least one face of the stationary part;
the movable member is adapted for being set to at least two different positions relative to the stationary part;
the stationary part comprises one or more fluid ports adapted for establishing fluid connections with corresponding fluid ports of the movable member;
the movable member is adapted for switching between two or more different flow paths of the microfluidic device;
the polymeric surface is implemented as a fluid-tight sealing surface;
the movable member is adapted for being set to at least two different positions relative to the stationary part, wherein in each of the different positions, different fluidic connections between the stationary part and the movable member are established and/or disconnected;
the microfluidic device is adapted for pressing the movable member against the stationary part in a fluid-tight manner.

9. The microfluidic device of claim 7 or any one of the above claims, wherein the movable member is a rotor element, the rotor element being pivotable around an axis of rotation perpendicular to the polymeric surface.

10. The microfluidic device of the preceding claim, further comprising one or more of the following:
the rotor element is adapted for being rotated into at least two different positions relative to the stationary part;
the rotor element is a component of a micro valve, and the stationary part serves as a stator element of the micro valve;
the rotor element is adapted for switching between different flow paths of the microfluidic device.

11. The microfluidic device of claim 7 or any one of the above claims, further comprising one or more of the following:
the movable member is adapted for being linearly moved into at least two different positions relative to the stationary part;
the movable member is a component of a microfluidic switch;
the stationary part is implemented as a multilayer structure;
the stationary part is composed of a stack of microstructured polymeric foils;
the stationary part comprises a separation system adapted for separating compounds of a given sample; wherein preferably the separation system is adapted for performing at least one of: liquid chromatography, gel electrophoresis, electrochromatography;
the stationary part is made of polymeric material, preferably of one of: polyimide, PEEK;
the movable member is made of polymeric material, preferably of one of: polyimide, PEEK.
